# EUROPÄISCHE PATENTSCHRIFT

(11) **EP 1 649 505 B1**
(45) Veröffentlichungstag und Bekanntmachung des Hinweises auf die Patenterteilung: **15.01.2014**
(21) Anmeldenummer: 04738743.6
(22) Anmeldetag: 19.06.2004
(51) Int. Cl.: H01L 21/265, H01L 21/285, H01L 21/336, H01L 29/47

(54) **VERFAHREN ZUR HERSTELLUNG EINES KONTAKTES**
METHOD FOR PRODUCING A CONTACT
PROCEDE DE PRODUCTION D'UN CONTACT

(30) Priorität: 25.07.2003 DE 10334353
(43) Veröffentlichungstag der Anmeldung: 26.04.2006
(73) Patentinhaber: Forschungszentrum Jülich GmbH, 52425 Jülich (DE)
(72) Erfinder: MANTL, Siegfried, 52428 Jülich (DE); ZHAO, Qing-Tai, 52428 Jülich (DE)
(86) Internationale Anmeldenummer: PCT/DE2004/001294
(87) Internationale Veröffentlichungsnummer: WO 2005/015629

(56) Entgegenhaltungen:
- US-A- 3 849 204
- US-A1- 2001 038 103
- US-A1- 2002 094 643
- TAO MENG ET AL: "Removal of dangling bonds and surface states on silicon (001) with a monolayer of selenium", APPLIED PHYSICS LETTERS, AIP, AMERICAN INSTITUTE OF PHYSICS, MELVILLE, NY, US, vol. 82, no. 10, 10 March 2003 (2003-03-10), pages 1559-1561, XP012033478, ISSN: 0003-6951, DOI: 10.1063/1.1559418
- SANKEY O F ET AL: "Si/transition-metal Schottky barriers: Fermi-level pinning by Si dangling bonds at interfacial vacancies", SOLID STATE COMMUNICATIONS, PERGAMON, GB, vol. 49, no. 1, 1 January 1984 (1984-01-01), pages 1-5, XP025700377, ISSN: 0038-1098, DOI: 10.1016/0038-1098(84)90548-9 [retrieved on 1984-01-01]

## Beschreibung

Die Erfindung betrifft Verfahren zur Herstellung eines ohmschen Kontaktes oder eines Schottky-Kontaktes mit einstellbaren Barrierenhöhe.

Ohmsche Metall-Halbleiter-Kontakte mit kleinem Kontaktwiderstand werden in der Mikroelektronik z. B. mittels Metall-Silizium-Verbindungen, sogenannten Siliziden, wie TiSi₂, CoSi₂, NiSi und so weiter, auf hochdotiertem Silizium realisiert.

Für die Ausgestaltung dieser hochdotierten Bereiche in Halbleitersubstraten sind Dotiertiefen im Silizium von mindestens 50 bis 100 Nanometer oder sogar mehr erforderlich. Die während der Ionenimplantation eingesetzten Dotierelemente, z. B. Arsen oder Bor, werden im Halbleiter in einer gewissen Breite verteilt. Eine anschließende thermische Behandlung führt zur Aktivierung der Dotierelemente und zur Diffusion dieser Dotierelemente in dem Halbleiter.

Nachteilig dehnt sich dadurch das Dotierprofil auf wenigstens 50 Nanometer, in der Praxis meist sogar auf einige 100 Nanometer aus.

Dies hat zur Folge, dass räumlich vergleichsweise große Kontakte entstehen, und die entsprechenden Bauelemente nicht weiter verkleinert werden können.

Die sogenannte Roadmap für die Silizium-Nanoelektronik erfordert aber eine weitere Reduzierung bzw. Skalierung dieser Dotierbereiche, um extrem flache Metall-Halbleiter-Übergänge zu bilden.

Für das Gebiet der Nanoelektronik ist es daher vorteilhaft, abrupte, idealer Weise atomar scharfe Metall-Halbleiter-Kontakte, die ohmsches Verhalten auf Halbleiterschichten wie Silizium zeigen, herzustellen. Damit sind Kontakte gemeint, die I-V-Kennlinien mit einer linearen Charakteristik aufweisen und deren Kontaktwiderstand möglichst klein ist.

Für viele Anwendungen sind Metall-Halbleiterkontakte mit Diodenverhalten, sogenannte Schottky-Kontakte, von großem Interesse. Diese zeigen eine nicht lineare Diodenkennlinie, die von der Schottky-Barriere abhängt. Bei der Herstellung derartiger Schottky-Kontakte ist es wünschenswert, die Barriere abzusenken, so dass Kontakte mit nahezu oder sogar vollständig ohmschen Verhalten entstehen.

Ohmsche- und Schottky-Kontakte werden durch eine Temperaturbehandlung in Wasserstoff- oder Deuterium-Atmosphäre passiviert, um die Dichte der nicht abgesättigten Bindungen an der Kontaktgrenzfläche zu reduzieren und so die elektrischen oder auch die optischen Eigenschaften zu verbessern.
Diese Art der Passivierung ändert nachteilig aber nicht die Schottky-Barriere oder die Austrittsarbeit des Metalls zu einer anderen Schicht. Weiterhin nachteilig ist, dass Wasserstoff bei relativ niedrigen Temperaturen von z.B. 200 bis 300°C wieder entweicht und so der Passivierungseffekt wieder aufgehoben wird.

Aus dem Stand der Technik sind erste Ergebnisse für Metalle bekannt, nach denen mittels einer Passivierung einer Grenzfläche mit Elementen der Gruppe VI des Periodensystems (Chalcogene) zwischen bestimmten reinen Metallen und einem Halbleiter ohmsches Verhalten derartiger Übergänge gezeigt wurde.

So ist aus Kaxiras (Phys. Rev. B 43, 6824 (1991)) bekannt, die Chalkogene Schwefel und Selen als Adsorbate zur Passivierung einer Silizium-Oberfläche zu nutzen. Dabei werden die freien Oberflächenbindungen (dangling bonds) des Siliziums durch die Adsorbate abgesättigt.

Aus Tao et al. (Appl. Phys. Lett. 82,1559 (2003)) ist bekannt, mittels einer Passivierungsschicht aus Selen einen ohmschen Kontakt mit Magnesium herzustellen. Hierfür wird unter Ultrahochvakuumbedingungen (UHV) Selen und Magnesium in einer Molekularstrahlepitaxieanlage auf einem Silizium-Substrat abgeschieden. Die Selen-Schicht hat dabei eine Dicke von einer Monolage, auf der das Metall unter UHV-Bedingungen abgeschieden wird.

Nachteilig an den gemäß Stand der Technik erzeugten Kontakten ist, dass diese Passivierungseffekte nur bis ca. 300 °C zeigen. Damit ist eine industrielle, das heißt auf Serienherstellung ausgerichtete Prozessierbarkeit von Silizium-Bauelementen aber nicht möglich. Weiterhin nachteilig sind die aus dem Stand der Technik bekannten Passivierungseffekte nur mit UHV-Abscheidung und nur mit einigen wenigen, reinen Metallen gezeigt worden.
Diese Verfahren sind ebenfalls nicht industrietauglich und daher zur serienmäßigen Herstellung von Metall-Halbleiter-Kontakten ungeeignet.

Aufgabe der Erfindung ist es daher, ein Verfahren zur Herstellung von Ohmschen Kontakten und von Schottky-Kontakten mit einstellbarer Barrierenhöhe zwischen einer ersten Schicht und einem zur ersten Schicht angrenzenden Substrat bereit zu stellen.

Es ist weiterhin Aufgabe der Erfindung derartige Kontakte aufweisende Bauelemente bereit zu stellen und deren besonderen Nutzen und vorteilhafte Eigenschaften gegenüber den Bauelementen aus dem Stand der Technik aufzuzeigen.

Die Aufgabe wird durch Verfahren gemäß Anspruchen 1 bis 3 gelöst. Vorteilhafte Ausgestaltungen ergeben sich aus den darauf jeweils rückbezogenen Patentansprüchen.

Ein Verfahren zur Herstellung des Kontaktes sieht vor, zunächst Chalkogen als Passivierungselement durch Ionenimplantation nahe der Grenzfläche zwischen der ersten Schicht und dem Substrat einzubringen.

Als Substratmaterial wird Silizium, Germanium, Si-Ge, Si-Ge-C Je nach der ersten Schicht gewählt.

Als erste Schicht kann ein Silizid oder ein Germanid gewählt werden.

Nach Implantation der Passivierungselemente erfolgt mittels einer Temperaturbehandlung und Segregation die Anreicherung der Passivierungselemente an der Grenzfläche der ersten Schicht zum Substrat.

Die Grenzfläche zwischen der ersten Schicht und dem Substrat wird durch Anreicherung der Passivierungselemente passiviert und zur Herstellung des Kontaktes zwischen erster und angrenzendem Substrat verwendet.

Mittels Passivierung der Grenzfläche wird hier also nicht nur die einfache Absättigung freier Bindungen an einer Silizium-Oberfläche verstanden. Vielmehr wird hier ein erweitertes Konzept vorgestellt, mit dem bei einem Metallsilizid-Halbleiter-Kontakt bzw. Metallgermanid-Halbleiter-Kontakt die Schottky-Barriere abgesenkt oder sogar ganz eliminiert werden kann. Die Temperaturbeständigkeit dieser Kontakte ist gegeben.

Während der Passivierung setzen sich die Passivierungselemente an die Enden freier Bindungen und füllen die Strukturen an der Grenzfläche von erster Schicht und angrenzender Schicht auf.

Das Substrat wird aus der Gruppe Silizium, verspanntes Silizium, Legierungen Si-C, Si-Ge, Si-Ge-C, Germanium, verspanntes Germanium gewählt.

Als Silizid kann ein halbleitendes Metall-Silizid gewählt werden.

Im Rahmen der Erfindung wurde erkannt, dass zur Herstellung eines derartigen Kontaktes die Passivierung der Grenzfläche der ersten Schicht zum angrenzenden Substrat vielfältigste Möglichkeiten der weiteren Prozessierung erlaubt, da dafür, im Gegensatz zum Stand der Technik, Silizide oder Germanide verwendet werden.

Die Silizide / Germanide zeichnen sich im Vergleich zu passivierten Metall-Halbleiter-Kontakten mit reinen Metallen als Kontakten vorteilhaft durch eine viel höhere thermische Stabilität und damit auch durch eine nachfolgend bessere Prozessierbarkeit aus.
Es sind daher besonders vorteilhaft temperaturfeste Kontakte herstellbar, die mit den Verfahren gemäß Stand der Technik nicht realisierbar sind.

Das aus dem Stand der Technik bekannte Verfahren der sequentiellen Abscheidung des Passivierungselementes und des Metalls ist nicht vergleichbar mit dem erfindungsgemäßen Verfahren. Vielmehr sieht das erfindungsgemäße Verfahren die selbstjustierende, das heißt lokal begrenzte Anreicherung eines Chalkogens an der Grenzfläche vor. Dies ist die Voraussetzung für elektronische Bauelemente mit bisher aus dem Stand der Technik nicht erreichten atomar scharfen ohmschen Kontakten auf angrenzenden Substraten, wie Halbleitern aus Silizium.

Das Chalkogen wird hierzu ionenimplantiert und durch eine anschließende Temperaturbehandlung an der Grenzfläche des Silizids zur angrenzenden Schicht angereichert.

Es ist hierzu möglich, das Chalkogen Passivierungselemente direkt nahe der Oberfläche in das Substrats einzubringen.

Entscheidend ist immer, dass nach Implantation des Chalkogens durch die Temperaturbehandlung die aktive Anreicherung des Chalkogens an der Grenzfläche der ersten Schicht zum angrenzenden Substrat erfolgt.

Für die Temperaturbehandlung kann die Schichtstruktur getempert werden.

Die Anreicherung des Chalkogens erfolgt mittels thermisch induzierter Segregation aus dem Substrat.

Voraussetzung hierfür ist, dass die Löslichkeit des Chalkogens in den Schichten klein genug ist. Die Anreicherung eines implantierten Chalkogens kann - wie erwähnt - auch während der thermisch induzierten Bildung der ersten Schicht, das heißt während der Silizid- oder Germanidbildung herbeigeführt werden.

Die Temperaturbehandlung wird dann in einer besonders vorteilhaften Ausgestaltung der Erfindung neben der Passivierung der Grenzflächen gleichzeitig zur Bildung der ersten Schicht genutzt.

Als Chalkogene werden Selen, Schwefel oder Tellur gewählt.
Chalkogene, wie Schwefel oder Selen zeigen besonders starke Segregationseffekte in Silizium und Siliziden/Germaniden, sodass die Grenzfläche zwischen der ersten Schicht und dem angrenzenden Substrat thermisch mit Schwefel oder Selen oder Tellur angereichert wird.

Zur Passivierung wird das Chalkogen vorteilhaft mit einer Dosis von 10¹² bis 10¹⁶ cm⁻² nahe der Grenzfläche der Schichtstruktur oder gegebenenfalls auch in die Oberfläche des Substrats eingebracht. Für eine vollständige Passivierung der Grenzfläche der ersten Schicht zum angrenzenden Substrat wird der Fachmann eine Dosis ansetzen, die einer Anreicherung von etwa einer Monolage des Passivierungselementes entspricht. Die Reduktion der Austrittsarbeit eines Silizides bzw. der Schottky-Barriere kann auch bei kleinerer Anreicherung erzielt werden.

Das Einbringen des für die Passivierung notwendigen Chalkogens kann somit, wie erwähnt, vor oder nach der Erzeugung des Silizids oder Germanids erfolgen. Vorteilhaft bewirkt dies, dass ein Fachmann die Abfolge der Verfahrensschritte dem Materialsystem anpassen kann.

Als Substrat ist nicht nur eine einfaches Substrat aus Silizium denkbar. Vielmehr kann auch verspanntes Silizium, oder Germanium, welches mit einem Metall zu einem Germanid reagiert, oder eine Legierung aus Si-Ge, Si-C, Si-Ge-C verwendet werden, da diese Schichten in der Zukunft von zunehmend größerer Bedeutung sein werden.

Es ist auch möglich, kein reines Silizium-Substrat, sondern die besonders dünne und serienmäßig bereits herstellbare Silizium-Deckschicht eines SOI-Substrates als Substrat oder auch ein SOI-Substrat mit verspanntem Silizium, Si-Ge, Si-Ge-C oder Germanium als Deckschicht zu wählen.

Die Bildung des Metallsilizids oder Metallgermanids erfolgt nach Stand der Technik durch Abscheidung eines Metalls auf das Silizium- oder Germanium-Substrat und anschließender Temperung oder durch eine zusätzliche selektive Abscheidung, meist selektiver Epitaxie von Silizium (oder Si-Ge), vor der Metalldeposition im Kontaktbereich und anschliessender Temperaturbehandlung.

Aus einer Germanium-Schicht entsteht bei der Temperaturbehandlung ein Germanid, aus einer Si-Ge Legierung wird ein ternäres M-Si-Ge-(M=Metall) Silizid gebildet.

Es ist auch möglich, als Metall-Silizid ein halbleitendes Silizid als erste Schicht zu wählen bzw. abzuscheiden oder zu bilden.
Als halbleitendes Silizid kommt z. B. Ru₂Si₃ oder β-FeSi₂ in Betracht. Mittels Passivierung der Grenzfläche zwischen Silizid und Silizium-Substrat können die Banddiskontinuitäten verändert werden. Unter der Voraussetzung, dass halbleitende Silizide durch Dotierung mit geeigneten Materialien, wie z. B. Mangan, Cobalt, Eisen, und so weiter magnetische Eigenschaften erhalten, und die Grenzfläche gegenüber dem Silizium-Substrat erfindungsgemäß passiviert wurde, ist es möglich, mit magnetischen Source- und Drain-Kontakten und einem Gate sogenannte Spin-Transistoren zu realisieren. Polarisierte Elektronen können von dem magnetischen Source Kontakt (magnetisches halbleitendes Silizid) in dem aus Silizium bestehenden Kanalbereich injiziert werden und mittels Feldeffekt, dem sogenannten Rashba Effekt (Rashba E. I., Fiz. Tverd. Tela (Leningrad) (1960), Sov. Phys. Solid State 2, 1109ff.) die Spinrichtung gedreht werden. Die Spindrehung verursacht beim Eintritt des polarisierten Elektrons in den magnetischen Drainbereich eine Widerstandstandänderung, die als Transistorsignal ausgelesen werden kann.

Der Metallanteil eines Metall-Silizids bzw. -Germanids wird vorteilhaft aus der Gruppe von Cobalt, Nickel, Titan, Platin, Wolfram und / oder Molybdän gewählt.

Das Metall-Silizid bzw. das Metall-Germanid wird dann vorteilhaft durch Temperung erzeugt, nachdem eine geeignete Metallschicht auf der angrenzenden silizium- oder germaniumhaltigen Substrat abgeschieden bzw. aufgebracht wurde.

Das Verfahren kann unter Einsatz einer Maske durchgeführt werden.
Dadurch wird vorteilhaft die Kontaktherstellung lateral begrenzt.

Besonders vorteilhaft ist, die für die selbstjustierende Bildung des Metallsilizids oder Metallgermanids nach dem Stand der Technik verwendete SiO₂-Maske gleichzeitig als Implantationsmaske für das Passivierungselement zu verwenden.

Die durch das Verfahren erzielten Vorteile beziehen sich somit auf die Herstellung von ohmschen Kontakten, bzw. von Schottky-Kontakten mit einstellbarer Barrierenhöhe durch Metallsilizid- oder Metallgermanid- Übergängen mit einstellbarer Austrittsarbeit. Dabei werden Materialien verwendet, die in der Mikroelektronik bereits serienmäßig prozessiert werden. Es lassen sich damit ohmsche Kontakte und auch negative Schottky-Barrieren einstellen. Negative Schottky-Barrieren sind besonders vorteilhaft für ultraschnelle Bauelemente verwendbar, da damit eine ballistische Injektion von Elektronen in eine angrenzende Schicht, z.B. in einen Halbleiter realisiert werden kann (Guo, J. und Lundstrom, M.S. (2002). IEEE Trans. Electron Devices 49, 1897ff.).

Es sind mit dem Verfahren z. B. auch ultraflache Metallsilizid-Halbleiterkontakte für Schottky-Barrieren-MOSFETs (SB-MOSFET; MOSFET: metal oxid semiconductor field effect transistor) herstellbar. Die ultraflachen Kontakte ermöglichen es, die Schottky-Barriere an dem Metallsilizid-Halbleiter-Übergang so zu reduzieren oder sogar ganz zu beseitigen, so dass negative Schottky-Barrieren gebildet werden. Dadurch wird eine Skalierung der SB-MOSFET's insbesondere auf silicon on insulator (SOI) Substraten auch in einer Multi-Gate Anordnung bis Gatelängen < 10 Nanometer möglich.

Im Falle eines halbleitenden Silizids als erste Schicht werden Spin-Transistoren realisierbar, die einen Spintransport vom halbleitenden Silizid in ein angrenzendes Substrat unter Ausnutzung des sogenannten Rashba-Effektes ermöglichen.

Im weiteren wird die Erfindung an Hand von Ausführungsbeispielen und der beigefügten Figuren näher beschrieben.

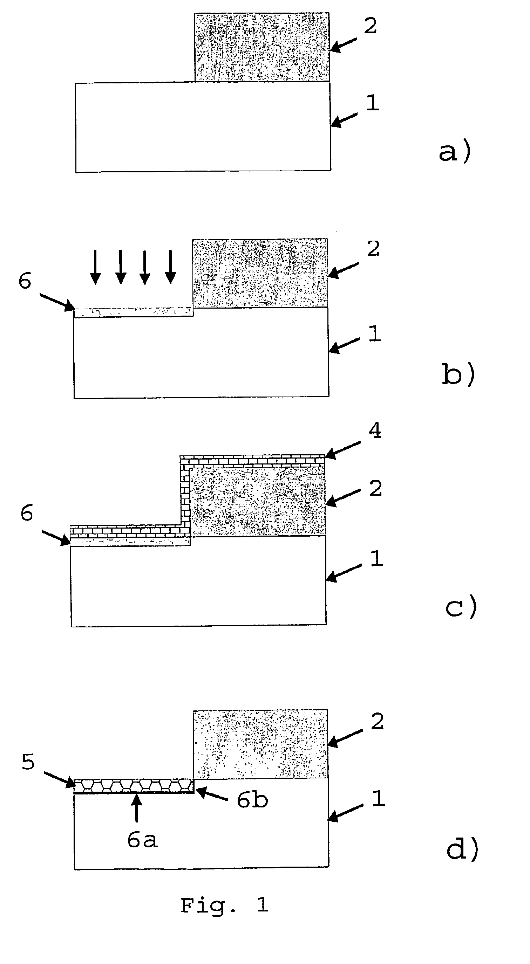

Fig. 1: Ausbildung eines passivierten Kontaktes zwischen einem Metallsilizid als erste Schicht und einem angrenzenden Halbleitersubstrat nach Implantation der Oberfläche des Halbleitersubstrats 1 mit einem Passivierungselement, also Chalkogen, und anschließender Abscheidung einer Metallschicht 4. Der Metallsilizid-Halbleiter-Kontakt wird durch passivierte Grenzflächen 6a, 6b des durch Temperung entstehenden Silizids 5 zum Halbleitersubstrat 1 ausgebildet.

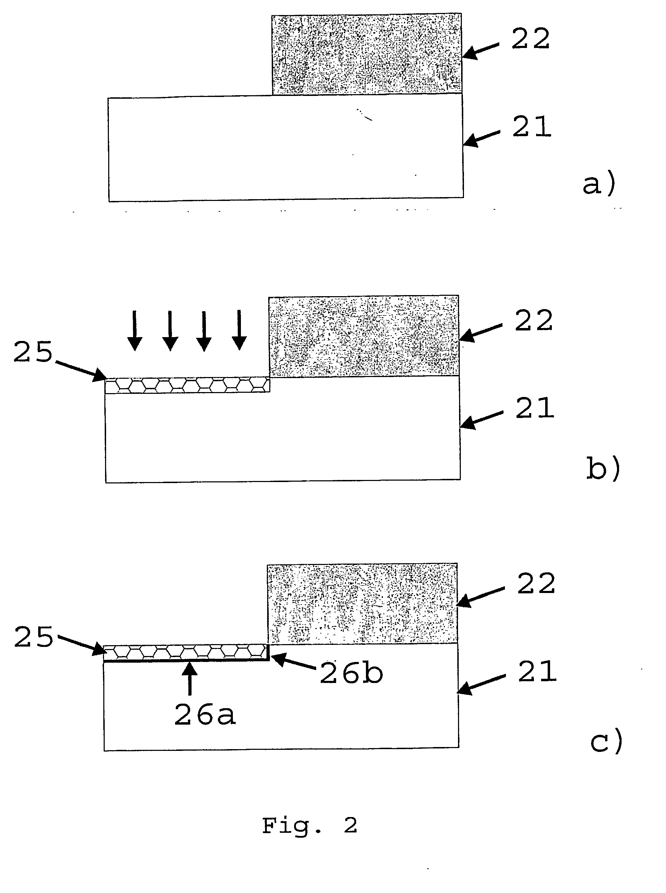

Fig. 2: Ausbildung eines passivierten Kontaktes zwischen einem Metallsilizid als erste Schicht und einem angrenzenden Halbleitersubstrat nach Abscheidung einer Metallschicht (nicht dargestellt) auf ein Halbleitersubstrat 21 und erster Temperung zur Bildung des Metallsilizids 25. Sodann Implantation nahe der Grenzfläche zwischen Metallsilizid und Halbleitersubstrat mit Passivierungselementen, also Chalkogen. Erneute Temperung zur Anreicherung der Passivierungselemente an den Grenzflächen 26a, 26b des Metallsilizids 25 zum Halbleitersubstrat 21.

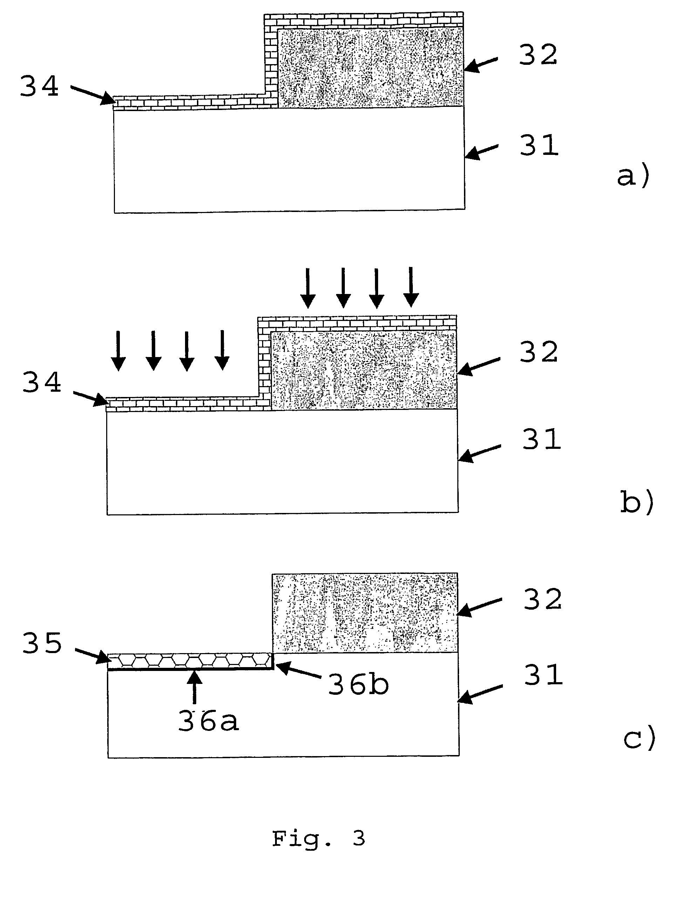

Fig. 3: Ausbildung eines passivierten Kontaktes zwischen einem Metallsilizid als erste Schicht und einem angrenzenden Halbleitersubstrat nach Abscheidung einer Metallschicht 34 auf ein Halbleitersubstrat 31. Sodann Implantation der Passivierungselemente, also Chalkogen, nahe der Grenzfläche zwischen Metall 34 und Halbleitersubstrat 31. Anschließend erfolgt eine einzige Temperaturbehandlung zur Bildung des Metallsilizids 35 und gleichzeitigen Anreicherung der Passivierungselemente an den Grenzflächen 36a, 36b des Metallsilizids 35 zum Halbleitersubstrat 31.

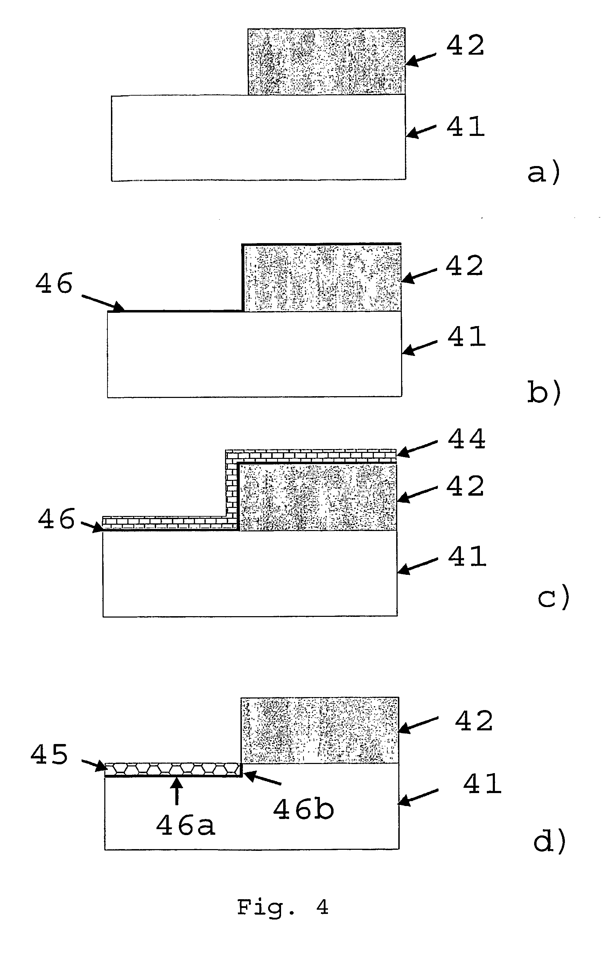

Fig. 4 fällt nicht unter die Erfindung und zeigt die Ausbildung eines passivierten Kontaktes zwischen einem Metallsilizid als erste Schicht und einem angrenzenden Halbleitersubstrat nach Abscheidung eines Passivierungselementes, also Chalkogen, als Schicht 46 auf der Oberfläche eines Halbleitersubstrats 41 und anschließender Abscheidung einer Metallschicht 44. Eine einzige Temperaturbehandlung zur Bildung des Metallsilizids 45 und gleichzeitigen Anreicherung der Passivierungselemente an den Grenzflächen 46a, 46b des Metallsilizids 45 zum Halbleitersubstrat 41. Die Silizidschicht 45 wird erst nach der Abscheidung des Passivierungselementes gebildet und die Anreicherung erfolgt während der Silizidbildung durch Schneepflugeffekt. Die Passivierungselemente werden nicht in das Silizid eingebaut.

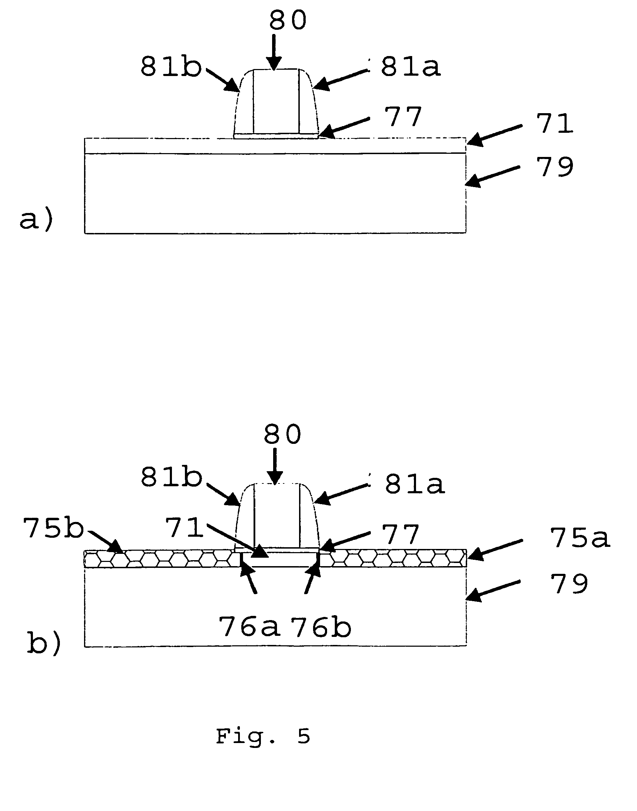

Fig. 5 Beispiel zur Herstellung eines Schottky-Barrieren (SB-) .MOSFETs mit mittels Passivierung modifizierter Schottky-Barriere. Die Passivierung der Grenzflächen 76a und 76b erfolgt durch Implantation der Passivierungselemente in den Source und Drain Bereichen der Siliziumschicht 71 als erste Schicht und optional auch in das Gatematerial 80 (z.B. Poly Silizium) (Fig. 5a)).

### Erstes Ausführungsbeispiel (Figur 1):

Zur Ausbildung eines passivierten Kontaktes zwischen einem Metallsilizid 5 als erste Schicht und einem Halbleitersubstrat 1 als angrenzendes Substrat wird zunächst eine Maske 2, z. B. aus SiO₂, auf ein siliziumhaltiges Halbleiter-Substrat 1, insbesondere aus reinem Silizium, aufgebracht (Figur 1a)). Mit Hilfe der Implantationsmaske 2 wird im weiteren die Kontaktherstellung lateral begrenzt.

Sodann wird Selen oder Schwefel oder Tellur als Chalkogen in das Halbleitersubstrat 1 nahe dessen Oberfläche, das heißt z. B. bis zu einigen 100 Nanometer Tiefe, implantiert. Dieser Vorgang ist durch Pfeile angedeutet (Figur 1b)). Die Dosis wird so gewählt, dass eine ausreichende Passivierung nach einer Temperaturbehandlung erzielt werden kann. Typischerweise wird hierzu mit einer Dosis von 10¹³-10¹⁵ cm⁻² implantiert. Zur Anreicherung des Chalkogens an der Oberfläche und um Implantationsdefekte auszuheilen erfolgt optional eine Temperaturbehandlung.

Nach Implantation und somit nach Bildung des implantierten Bereichs 6 auf bzw. in dem Halbleitersubstrat 1 erfolgt die Herstellung des Metallsilizid-Halbleiter-Kontaktes. Hierzu wird zunächst der metallische Anteil 4 des Silizids, ausgewählt aus der Gruppe von z. B. Kobalt, Nickel, Titan, Platin, Wolfram oder Molybdän, als dünne Schicht von z. B. 5 bis 50 Nanometern abgeschieden. Im Falle von Kobalt als Metall wird bevorzugt noch eine zusätzliche Titan-Schutzschicht von z. B. 10 Nanometern deponiert, bevor eine zweistufige Temperung zur Silizidbildung durchgeführt wird (nicht dargestellt). Nach der ersten Temperung bei ca. 550 °C werden nicht reagierte Metallschichten selektiv abgeätzt. Die zweite Temperung erfolgt in einem Temperaturbereich von 700-900°C z. B. für 30 Sekunden. Da die Silizidbildung in dem vorher mit dem Chalkogen implantierten Bereich außerhalb der Maske 2 erfolgt, wird das Chalkogen bevorzugt an den Grenzflächen 6a, b des Metallsilizids 5 zum Halbleitersubstrat 1 angereichert, und so eine effiziente Passivierung erreicht. Durch die gleichzeitige Verwendung einer SiO₂-Maske als Implantationsmaske und zur Silizidbildung erfolgt auch die Bildung der passivierten Grenzflächen selbstjustierend, da die Silizidbildung und die Passierung durch die Maske auf identische Bereiche begrenzt wird.

Als Resultat wird ein ohmscher Kontakt oder ein Schottky-Kontakt mit kleiner, bei besonders effizienter Passivierung mittels hoher Anreicherung des Passivierungselementes an der Grenzfläche 6a, b, sogar mit negativer Schottky-Barriere erzeugt.

### Zweites Ausführungsbeispiel (Figur 2):

Zur Ausbildung eines passivierten Kontaktes zwischen einem Metallsilizid 25 als erste Schicht und einem Halbleitersubstrat 21 als angrenzendes Substrat wird wiederum zuerst eine Maske 22, z. B. aus SiO₂ auf ein Halbleiter-Substrat 21, insbesondere aus Silizium als Halbleiter, aufgebracht (Figur 2a). Mit Hilfe der Implantationsmaske 22 aus z. B. SiO₂ wird im weiteren die Kontaktherstellung lateral begrenzt.

Im Gegensatz zum ersten Ausführungsbeispiel wird vor der durch Pfeile angedeuteten Implantation eines Chalkogens zunächst das Metallsilizid 25 auf dem Halbleitersubstrat 21 erzeugt. Hierzu wird ein Metall auf die Struktur von Fig. 2a aufgebracht und nach dem Stand der Technik selbstjustierend in dem nicht mit der Maske 22 abgedeckten Bereich durch Temperaturbehandlung in ein Silizid 25 umgewandelt. Der Metallsilizid-Halbleiter-Kontakt besteht aus z. B. TiSi₂, CoSi₂, NiSi, NiSi₂, PtSi, WSi₂ oder aus einem anderen Metall-Silizid 25 zum Halbleitersubstrat 21. Das Metallsilizid 25 weist, wie aus dem ersten Ausführungsbeispiel bekannt, horizontal und vertikal zu dem Silizium-Halbleitersubstrat 21 verlaufende Grenzflächen 26a, 26b auf. Das Metallsilizid 25 ist somit auch in oder auf dem Silizium-Substrat 21 angeordnet.

Erst nach Herstellung des Silizids 25 wird ein Chalkogen, z. B. Schwefel oder Selen oder Tellur nahe der Grenzfläche zwischen Metall-Silizid 25 und Silizium-Halbleitersubstrat 21 implantiert (Figur 2b). Die Dosis wird so gewählt, dass nach einer Temperung eine ausreichende Passivierung erreicht wird. Beispielsweise werden 7x10¹⁴ Se⁺ cm⁻² nahe der Grenzflächen implantiert und anschließend bei Temperaturen von z. B. 700-1000°C getempert. Die Grenzflächen 26a und 26b werden dabei mit dem Passivierungselement angereichert. Dadurch wird die Schottky-Barriere des Silizides 25 an der Grenzfläche 26a und 26b zum Substrat 21 reduziert und mit zunehmender Passivierung verringert, so dass ein ohmscher Kontakt (Barriere = 0) bzw. ein negativer Schottky-Kontakt entsteht. Die Anreicherung wird durch die Implantationsdosis und das Segrationsverhalten des Passivierungselementes in dem Substrat bestimmt.

### Drittes Ausführungsbeispiel (Figur 3):

Zur Ausbildung eines passivierten Kontaktes zwischen einem Metallsilizid 35 als erste Schicht und einem Halbleitersubstrat 31 als angrenzendes Substrat wird wiederum zuerst eine Maske 32, z. B. aus SiO₂, auf das Halbleiter-Substrat 31, insbesondere aus Silizium als Halbleiter, aufgebracht (Figur 3a). Mit Hilfe der Implantationsmaske 32 aus z. B. SiO₂ wird im weiteren die Kontaktherstellung lateral begrenzt.

Vor der Implantation, dargestellt durch Pfeile in Figur 3b, wird ein Metall 34, ausgewählt aus der Gruppe von z. B. Cobalt, Nickel, Titan, Platin, Wolfram oder Molybdän, als dünne Metallschicht 34 von z. B. 5 bis 50 Nanometern abgeschieden (Fig. 3a)).

Sodann erfolgt die Implantation, wiederum dargestellt durch Pfeile, direkt in die Metallschicht 34 nahe der Grenzfläche von Metallschicht 34 zum angrenzenden Substrat 31 (Fig. 3b). Während der thermisch aktivierten Bildung des Metallsilizids 35 reichern sich die Passivierungselemente, also Chalkogen, durch Segregation aus dem angrenzenden Substrat 31 und / oder Ausdiffusion aus dem Metallsilizid 35 an den Grenzflächen 36a, 36b an, und erzeugen so den erwünschten Kontakt (Fig. 3c)). Eine selektive Ätzung kann zur Entfernung nicht reagierter Metallschichten angewendet werden.

### Beispiel ausserhalb der Erfindung (Fig. 4)

Zur Ausbildung eines passivierten Kontaktes zwischen einem Metallsilizid 45 als erste Schicht und einem Halbleitersubstrat 41 als angrenzendem Substrat wird zunächst wiederum eine Maske 42, z. B. aus SiO₂, auf ein Halbleiter-Substrat 41, insbesondere auf Silizium als Halbleiter, aufgebracht (Figur 4a)). Mit Hilfe der Implantationsmaske 42 aus z. B. SiO₂ wird im weiteren die Kontaktherstellung lateral begrenzt.

Auf diese Schichtstruktur 42, 41 wird zunächst eine Chalkogenschicht 46, z. B. eine Monolage, abgeschieden (Fig. 4b)).

Sodann wird auf diese Schicht 46 ein Metall 44 abgeschieden. (Fig. 4c)). Das Metall kann hierzu aus der Gruppe von z. B. Cobalt, Nickel, Titan, Platin, Wolfram oder Molybdän, als dünne Schicht 44 von z. B. 5 bis 50 Nanometern auf die Chalkogenschicht 46 abgeschieden werden.

Durch Temperung wird der Kontakt aus Metallsilizid 45 zum Halbleitersubstrat 41 aus dem vorher mit dem Chalkogen abgeschiedenen Bereich des Silizium-Halbleitersubstrats 41 und dem Metall 44 gebildet. Dabei wird das Chalkogen an den Grenzflächen 46a, 46b des Metallsilizids zum Halbleitersubstrat 41 angereichert und so eine effiziente Passivierung erreicht. Die entstehende Schichtsstruktur wird thermisch so behandelt, dass durch Silizidbildung ein passivierter Silizidkontakt entsteht (Figur 4d)). Dies bedeutet, dass eine Temperaturbehandlung sowohl für die Silizidierung und damit zur Herstellung des Metallsilizid-Halbleiter-Kontaktes als auch zur Passivierung der Grenzflächen 46a, 46b genutzt wird.

In den Ausführungsbeispielen 1 bis 3 sind somit als angrenzende Schichten jeweils Halbleiterschichten mit Substratfunktion angegeben.

Fig. 5 zeigt die Herstellung eines Schottky-Barrieren MOSFETs mit durch Passivierung negativen Schottky-Barrieren der Source und Drain-Kontakte.

Auf einem SOI-Substrat mit einer dünnen Silizium-Oberflächenschicht 71 von 5-50 Nanometer auf einer SiO₂-Schicht 79 oder auf einer Oberflächenschicht aus Silizium 71 auf einer Si-Ge-Schicht 79 werden nach Herstellung der Gatestruktur 80, 81a, 81b (Fig. 5a)) die Source- und Drain-Kontakte 75a, b durch Silizidierung und Passivierung nach einem der in den Ausführungsbeispielen 1 bis 3 beschriebenen Verfahren hergestellt (Fig. 5b)).

Die Bauelementestruktur der Fig. 5a) besteht aus einem Dielektrikum 77, welches auf der Halbleiterschicht aus Silizium 71 angeordnet ist. Der Gatekontakt 80, die Isolationsspacer 81a und 81b und das Dielektrikum 77 sind, wie erwähnt, auf einem silicon on insulator oder auf einem SiGe-Substrat 71, 79 angeordnet Fig. 5a)). Die fertige Bauelementestruktur weist Metallsilizide 75a, b als erste Schicht mit Funktion von Schottky-Source und Drain auf. Die Grenzflächen von Source und Drain 76a, b zum MOSFET Kanal 71 als angrenzende Schicht sind durch eine Temperaturbehandlung mit Chalkogen als Passivierungselement angereichert.

Die Passivierung kann z. B. durch Implantation der Passivierungselemente in die späteren Source- und Drain-Bereiche der Siliziumschicht 71 erfolgen. Anschließend wird ein Metall abgeschieden (nicht dargestellt) und durch eine Temperaturbehandlung selbstjustierend das Metallsilizid 75a, b als Source und Drain, gebildet. Das nicht reagierte Metall auf den Spacern 81a und 81b wird nasschemisch entfernt. Die Passivierungselemente reichern sich während der thermischen Behandlung an den Grenzflächen 76a, b an und reduzieren die Schottky-Barriere des Silizides 75a, b. Je nach Anreicherungsgrad entsteht ein Kontakt mit kleiner oder negativer Barriere. Ein ohmscher Kontakt ist herstellbar, wenn die Barriere vollständig abgebaut wird, das heißt die Barrierenhöhe = 0 ist.

Besonders vorteilhaft ist es, als Ausgangs-Schichtstruktur die Silizium-Schicht 71 eines SOI-Substrats mit einer Dicke von etwa < 30 Nanometer so klein zu wählen, dass full-depleted MOSFETs gebildet werden können.

### Wenn die Gatelänge extrem klein, das heißt kleiner etwa 30 Nanometer gewählt wird und die Passivierung der Co-Si₂ bzw. NiSi-Source/Drain-Kontakte 75a, 75b z. B. mit Selen an der Source und Drainseite des Kontaktes in Kanalrichtung 76a, 76b zu einer negativen Schottky-Barriere führen, ist vorteilhaft ballistischer Transport von Ladungsträgern möglich, wie mittels Simulationsrechnungen von Lundström gezeigt wurde.

### Weiteres Beispiel (Fig. 5)

Schottky-Barrieren-Mosfet mit verspanntem Silizium bzw. mit Si-Ge-Schicht bzw. Si-Ge-C-Schicht 71:
Anstelle einer normalen Silizium-Schicht of SOI kann besonders vorteilhaft auch verspanntes Silizium oder Si-Ge, Si-Ge-C 71 auf SiO₂ 79 für die Herstellung von Schottky-Barrieren Mosfets eingesetzt werden.

Die Silizidierung und die Passivierung erfolgt wie in den vorhergehenden Beispielen.

### Anderes Beispiel:

Alternativ zu den genannten metallischen Siliziden können zur Ausbildung eines Kontaktes zwischen einem halbleitendem-Silizid als erste Schicht und einem Halbleitersubstrat als angrenzenden Substrat die halbleitenden Silizide (z.B. Ru₂Si₃, β-FeSi₂) auf dem angrenzenden Substrat aufgebracht werden und mittels Passivierung nach einem der oben genannten Verfahren, die Bandkantendiskontinuitäten des Silizid/Silizium-Kontaktes verändert werden. Dadurch kann der elektrische Transport vom Silizid zum Silizium vorteilhaft beeinflusst werden.

Besonders vorteilhaft ist die Passivierung einer Grenzfläche zwischen einem halbleitenden Silizid mit magnetischen Eigenschaften und dem Silizium als Halbleitersubstrat. Halbleitende Silizide, wie z. B. Ru₂Si₃, β-FeSi₂, weisen nach Dotierung mittels Mn, Co, Fe magnetische Eigenschaften auf.

Das in Fig. 5b dargestellte Bauelement stellt einen Spintransistor dar, wenn die Source und Drain-Kontakte aus einem magnetischen, halbleitenden Silizid 75a, b gefertigt werden. Die Passivierung an der Grenzfläche begünstigt den Spintransport. Durch Anlegen eines Gatepotentials kann mittels Rashba-Effekt die Spinrichtung gedreht werden, so dass ein Spintransistor realisiert wird.

Es ist grundsätzlich möglich, an Stelle der genannten Metallsilizide in den Ausführungsbeispielen auch Metalgermanide als erste Schichten zu wählen. Insbesondere die erfindungsgemäß hergestellten Kobaltdisilizid-Halbleiter-Kontakte sind temperaturstabil.

Anstelle der oben beschriebenen single-Gate MOSFETs können auch Multi-Gate MOSFETs (FinFETs, Omega-Gate) mit solchen Kontakten hergestellt werden.

### Bezugszeichenliste:

1; 21; 31; 41; 71: Halbleitersubstrat als angrenzendes Substrat, insbesondere aus Silizium.
2; 22; 32; 42: Maske z. B. aus SiO₂, Si₃N₄ etc.
4; 34; 44: Metall zur Bildung des Metallsilizids
5; 25; 35; 45; 75a, b: Metallsilizid als erste Schicht
6; 46: mit Passivierungselementen versehener Bereich 6; Passivierungsschicht 46
6a, b; 26a, b; 36a, b; 46a, b; 76a, b: passivierte Grenzfläche zwischen Metallsilizid und Halbleiterschicht
77: Gate-Dielektrikum (SiO₂, Si₃N₄, high k Material)
79: Tragschicht, z. B. Silizium-Substrat
71: Silizium- oder verspannte Silizium- oder Germanium-Halbleiterschicht, oder Si-Ge-, oder Si-Ge-C- oder Si-C-Schicht als angrenzendes Substrat.
75a, b: Metallsilizid als Source und Drain
76a, b: passivierte Grenzfläche zwischen Metallsilizid und Halbleiter, hier jeweilige Grenzfläche zwischen Source 75a bzw. Drain 75b und Kanalbereich 71.
79: SiO₂ oder SiGe
80: Gate-Kontakt (poly-Si, Poly-SiGe, Metall, Silizid)
81a, b: Spacer (SiO₂, Si₃N₄)

## Patentansprüche

1. Verfahren zur Herstellung eines ohmschen Kontaktes oder eines Schottky-Kontaktes mit einstellbarer Barrierenhöhe zwischen einer ersten Schicht (25) aus einem Metallsilizid und einem hieran angrenzenden Substrat aus der Gruppe Silizium, verspanntes Silizium, Legierungen Si-C, Si-Ge, Si-Ge-C oder einer ersten Schicht aus einem Metallgermanid und einem hieran angrenzenden Substrat aus der Gruppe Germanium, verspanntes Germanium, Legierungen Si-Ge, Si-Ge-C (21),
**gekennzeichnet durch** die Schritte:
a) ein Chalkogen als Passivierungselement wird durch Ionenimplantation nahe der Grenzfläche zwischen der ersten Schicht und dem Substrat eingebracht;
b) das Chalkogen wird **durch** Temperaturbehandlung und Segregation an der Grenzfläche (26a, b) der ersten Schicht zum angrenzenden Substrat zur Bildung des Kontakts angereichert.

2. Verfahren zur Herstellung einer ersten Schicht (5) aus einem Metallsilizid auf einem hieran angrenzenden Substrat aus der Gruppe Silizium, verspanntes Silizium, Legierungen Si-C, Si-Ge, Si-Ge-C oder einer ersten Schicht aus einem Metallgermanid auf einem hieran angrenzenden Substrat aus der Gruppe Germanium, verspanntes Germanium, Legierungen Si-Ge, Si-Ge-C (1) gemeinsam mit der Herstellung eines ohmschen Kontaktes oder eines Schottky-Kontaktes mit einstellbarer Barrierenhöhe zwischen der ersten Schicht und dem Substrat, **gekennzeichnet durch** die Schritte:
a) ein Chalkogen als Passivierungselement wird durch Ionenimplantation nahe der Oberfläche des Substrats eingebracht;
b) der metallische Anteil der ersten Schicht wird auf dem implantierten Substrat abgeschieden;
c) die erste Schicht wird **durch** Temperaturbehandlung gebildet während gleichzeitig **durch** Segregation das Chalkogen an der Grenzfläche (6a, b) zwischen der ersten Schicht und dem Substrat zur Bildung des Kontakts angereichert wird.

3. Verfahren zur Herstellung einer ersten Schicht (35) aus einem Metallsilizid auf einem hieran angrenzenden Substrat aus der Gruppe Silizium, verspanntes Silizium, Legierungen Si-C, Si-Ge, Si-Ge-C oder einer ersten Schicht aus einem Metallgermanid auf einem hieran angrenzenden Substrat aus der Gruppe Germanium, verspanntes Germanium, Legierungen Si-Ge, Si-Ge-C (31) gemeinsam mit der Herstellung eines ohmschen Kontaktes oder eines Schottky-Kontaktes mit einstellbarer Barrierenhöhe zwischen der ersten Schicht und dem Substrat, **gekennzeichnet durch** die Schritte:
a) der metallische Anteil der ersten Schicht wird auf dem Substrat abgeschieden;
b) ein Chalkogen als Passivierungselement wird durch Ionenimplantation nahe der Grenzfläche zwischen der metallischen Schicht und dem Substrat eingebracht,
c) die erste Schicht wird **durch** Temperaturbehandlung gebildet während gleichzeitig **durch** Segregation das Chalkogen an der Grenzfläche (36a, b) zwischen der ersten Schicht und dem Substrat zur Bildung des Kontakts angereichert wird.

4. Verfahren nach einem der vorhergehenden Ansprüche, **gekennzeichnet durch**
Wahl von Selen, Schwefel oder Tellur als Chalkogen.

5. Verfahren nach einem der vorhergehenden Patentansprüche,
**dadurch gekennzeichnet, dass**
das Chalkogen als Passivierungselement mit einer Dosis von 10¹² bis 10¹⁶ cm⁻², insbesondere 10¹⁴ bis 10¹⁵ cm⁻² implantiert wird.

6. Verfahren nach einem der vorhergehenden Patentansprüche,
**dadurch gekennzeichnet, dass**
der Metallanteil eines Metallsilizids oder Metallgermanids aus der Gruppe von Cobalt, Nickel, Titan, Platin, Wolfram und / oder Molybdän ausgewählt wird.

7. Verfahren nach einem der vorhergehenden Ansprüche 2 bis 5, **dadurch gekennzeichnet, dass** ein halbleitendes Silizid aus der Gruppe β-FeSi₂, Ru₂Si₃, MnSiₓ oder CrSi₂ als Metallsilizid gewählt wird.

8. Verfahren nach Anspruch 7, **dadurch gekennzeichnet, dass** das halbleitende Silizid mit Fe, Co oder Mn magnetisch dotiert wird.

9. Verfahren nach einem der vorhergehenden Ansprüche 1 bis 8, **dadurch gekennzeichnet, dass** der Kontakt als negative Schottky-Barriere ausgebildet wird.

10. Verwendung eines nach einem der vorhergehenden Ansprüche 1 bis 9 hergestellten Kontakts als Source- oder Drain-Kontakt eines Schottky-Barrieren MOSFET.

11. Verwendung eines nach einem der vorhergehenden Ansprüche 1 bis 9 hergestellten Kontakts als magnetischer Source- oder Drainkontakt eines Spin-Transistors, wobei als erste Schicht ein halbleitendes, mit Mn oder Fe oder Co dotiertes silizid gewählt wird.

## Claims

1. Method for producing an ohmic contact or a Schottky contact with an adjustable barrier height between a first layer (25) made from a metal silicide and a substrate adjoining this made from the silicon, strained silicon, Si-C, S-Ge and Si-Ge-C alloy group or a first layer made from a metal germanide and a substrate adjoining this made from the germanium, strained germanium, Si-Ge and Si-Ge-C alloy group (21), **characterised by** the steps:
a) a chalcogen is introduced as a passivating element by ion implantation near the interface (26a, b) between the first layer and the substrate;
b) the chalcogen is enriched by heat treatment and segregation at the interface of the first layer with the adjoining substrate to form the contact.

2. Method for producing a first layer (5) made from a metal silicide on a substrate adjoining this made from the silicon, strained silicon, Si-C, Si-Ge and Si-Ge-C alloy group or a first layer made from a metal germanide on a substrate adjoining this made from the germanium, strained germanium, Si-Ge and Si-Ge-C alloy group (1) as well as producing an ohmic contact or a Schottky contact with an adjustable barrier height between the first layer and the substrate,
**characterised by** the steps:
a) a chalcogen is introduced as a passivating element by ion implantation near the surface of the substrate;
b) the metal part of the first layer is deposited on the implanted substrate;
c) the first layer is formed by heat treatment whilst at the same time the chalcogen at the interface (6a, b) between the first layer and the substrate is enriched by segregation to form the contact.

3. Method for producing a first layer (35) made from a metal silicide on a substrate adjoning this made from the silicon, strained silicon, Si-C, Si-Ge and Si-Ge-C alloy group or a first layer made from metal germanide on a substrate adjoining this made from the germanium, strained germanium, Si-Ge and Si-Ge-C alloy group (31), as well as producing an ohmic contact or a Schottky contact with an adjustable barrier height between the first layer and the substrate,
**characterised by** the steps:
a) the metal part of the first layer is deposited on the substrate:
b) a chalcogen is introduced as a passivating element by ion implantation near the interface between the first layer and the substrate;
c) the first layer is formed by heat treatment whilst at the same time the chalcogen at the interface (36a, b) between the first layer and the substrate is enriched by segregation to form the contact.

4. Method according to one of the previous claims,
**characterised by**
the selection of selenium, sulphur or tellurium as the chalcogen.

5. Method according to one of the previous patent claims,
**characterised in that**
the chalcogen is implanted with a dose of 10¹² to 10¹⁶ cm⁻², particularly 10¹⁴ to 10¹⁵ cm⁻², as a passivating element.

6. Method according to one of the previous patent claims,
**characterised in that**
the metal part of a metal silicide or metal germanide is selected from the cobalt, nickel, titanium, platinum, wolfram and / or molybdenum group.

7. Method according to one of previous claims 2 to 5, **characterised in that** a semiconducting silicide is selected from the ß-FeSi₂, Ru₂Si₃, MnSiₓ or CrSi₂ group as a metal silicide.

8. Method according to claim 7, **characterised in that** the semiconducting silicide is doped magnetically with Fe, Co or Mn.

9. Method according to one of previous claims 1 to 8, **characterised in that** the contact is formed as a negative Schottky barrier.

10. Use of a contact produced according to previous claims 1 to 9 as a source or drain contact of a Schottky barrier MOSFET.

11. Use of a contact produced according to one of previous claims 1 to 9 as a magnetic source or drain contact of a spin transistor, in which a semiconducting silicide doped with Mn or Fe or Co is selected as the first layer.

## Revendications

1. Procédé de fabrication d'un contact ohmique ou d'un contact Schottky présentant une hauteur de barrière ajustable entre une première couche (25) constituée d'un siliciure métallique et un substrat adjacent à cette dernière choisi parmi le groupe comprenant le silicium, le silicium sollicité, des alliages Si-C, Si-Ge, Si-Ge-C ou entre une première couche constituée de germaniure métallique et un substrat adjacent à cette dernière choisi parmi le groupe comprenant le germaniure, le germaniure sollicité, des alliages Si-Ge, Si-Ge-C (21),
**caractérisé par** les étapes suivantes :
a) un chalcogène est mis en place en tant qu'élément de passivation par implantation ionique, à proximité de la surface limite entre la première couche et le substrat,
b) le chalcogène est enrichi par traitement thermique et par ségrégation au niveau de la surface limite (26a) entre la première couche et le substrat adjacent aux fins de la formation du contact.

2. Procédé de fabrication d'une première couche (5) constituée d'un siliciure métallique sur un substrat adjacent à cette dernière choisi parmi le groupe comprenant le silicium, le silicium sollicité, des alliages Si-C, Si-Ge, Si-Ge-C ou d'une première couche constituée d'un germaniure métallique sur un substrat adjacent à cette dernière choisi parmi le groupe comprenant le germaniure, le germaniure sollicité, des alliages Si-Ge, Si-Ge-C (1), ainsi que de fabrication d'un contact ohmique ou d'un contact Shottky présentant une hauteur de barrière ajustable entre la première couche et le substrat,
**caractérisé par** les étapes suivantes :
a) un chalcogène est mis en place en tant qu'élément de passivation par implantation ionique, à proximité de la surface du substrat ;
b) la proportion métallique de la première couche est déposée sur le substrat implanté ;
c) la première couche est formée par traitement thermique, alors que dans le même temps le chalcogène est enrichi par ségrégation au niveau de la surface limite (6a, 6b) entre la première couche et le substrat aux fins de la formation du contact.

3. Procédé de fabrication d'une première couche (35) constituée d'un siliciure métallique sur un substrat adjacent à cette dernière choisi parmi le groupe comprenant le silicium, le silicium sollicité, des alliages Si-C, Si-Ge, Si-Ge-C ou d'une première couche constituée d'un germaniure métallique sur un substrat adjacent à cette dernière choisi parmi le groupe comprenant le germanium, le germanium sollicité, des alliages Si-Ge, Si-Ge-C (31), ainsi que de fabrication d'un contact ohmique ou d'un contact shottky présentant une hauteur de barrière ajustable entre la première couche et le substrat,
**caractérisé par** les étapes suivantes :
a) la proportion métallique de la première couche est déposée sur le substrat ;
b) un chalcogène est mis en place en tant qu'élément de passivation par implantation ionique à proximité de la surface limite entre la couche métallique et le substrat ;
c) la première couche est formée par traitement thermique, alors que dans le même temps, le chalcogène est enrichi par ségrégation au niveau de la surface limite (36a) entre la première couche et le substrat aux fins de la formation du contact.

4. Procédé selon l'une quelconque des revendications précédentes,
**caractérisé par**
la sélection du chalcogène parmi le sélénium, le souffre ou le tellure.

5. Procédé selon l'une quelconque des revendications précédentes,
**caractérisé en ce que**
le chalcogène est implanté en tant qu'élément de passivation avec une dose allant de 10¹² à 10¹⁶ cm⁻², en particulier allant de 10¹⁴ à 10¹⁵ cm⁻².

6. Procédé selon l'une quelconque des revendications précédentes,
**caractérisé en ce que**
la proportion métallique d'un siliciure métallique ou d'un germaniure métallique est choisie parmi le groupe comprenant le cobalt, le nickel, le titane, la platine, le tungstène et/ou le molybdène.

7. Procédé selon l'une quelconque des revendications 2 à 5, **caractérisé en ce qu'**on choisit en tant que siliciure métallique, un siliciure semi-conducteur parmi le groupe comprenant les composés suivants : ß-FeSi₂, Ru₂Si₃, MnSiₓ ou CrSi₂.

8. Procédé selon la revendication 7, **caractérisé en ce que** le siliciure semi-conducteur est dopé de manière magnétique avec du Fe, Co ou du Mn.

9. Procédé selon l'une quelconque des revendications 1 à 8, **caractérisé en ce que** le contact est réalisé sous la forme d'une barrière Schottky négative.

10. Utilisation d'un contact fabriqué selon l'une quelconque des revendications 1 à 9 en tant que contact de source ou de drain d'un MOSFET à barrière de Schottky.

11. Utilisation d'un contact fabriqué selon l'une quelconque des revendications précédentes 1 à 9 en tant que contact de source ou de drain magnétique d'un transistor à spin, sachant qu'on choisit comme première couche un siliciure semi-conducteur dopé avec du Mn ou du Fe ou du Co.
